# EUROPÄISCHE PATENTSCHRIFT

(11) **EP 2 811 314 B1**
(45) Veröffentlichungstag und Bekanntmachung des Hinweises auf die Patenterteilung: **07.09.2016**
(21) Anmeldenummer: 13170893.5
(22) Anmeldetag: 06.06.2013
(51) Int. Cl.: G01R 33/06, G01R 33/18, G01R 33/00

(54) **Magnetfeldmessvorrichtung mit Vibrationskompensation**
Magnetic field measuring device with vibration compensation
Dispositif de mesure du champ magnétique avec compensation des vibrations

(43) Veröffentlichungstag der Anmeldung: 10.12.2014
(73) Patentinhaber: Christian-Albrechts-Universität zu Kiel, 24118 Kiel (DE)
(72) Erfinder: Jahns, Robert, 24107 Kiel (DE); Runkowske, Holger, 24253 Probsteierhagen (DE); Knöchel, Reinhard, 25336 Elmshorn (DE)
(74) Vertreter: Hansen, Jochen

(56) Entgegenhaltungen:
- STEPHAN MARAUSKA ET AL: "Paper;MEMS magnetic field sensor based on magnetoelectric composites;MEMS magnetic field sensor based on magnetoelectric composites", JOURNAL OF MICROMECHANICS & MICROENGINEERING, INSTITUTE OF PHYSICS PUBLISHING, BRISTOL, GB, Bd. 22, Nr. 6, 22. Mai 2012 (2012-05-22), Seite 65024, XP020224204, ISSN: 0960-1317, DOI: 10.1088/0960-1317/22/6/065024
- XING ZENGPING ET AL: "Investigation of external noise and its rejection in magnetoelectric sensor design", JOURNAL OF APPLIED PHYSICS, AMERICAN INSTITUTE OF PHYSICS. NEW YORK, US, Bd. 106, Nr. 2, 28. Juli 2009 (2009-07-28) , Seiten 24512-24512, XP012123655, ISSN: 0021-8979, DOI: 10.1063/1.3176500

## Beschreibung

Die Erfindung betrifft eine Magnetfeldmessvorrichtung umfassend eine Mehrzahl magnetoelektrischer Sensoren.

Magnetoelektrische Sensoren, im Folgenden kurz ME-Sensoren, eignen sich zur Detektion u. a. kleiner zeitlich veränderlicher Magnetfelder, wie sie etwa durch biologische Aktionsströme in lebenden Organismen hervorgerufen werden, z.B. menschliche Hirnströme. ME-Sensoren bilden eine mögliche Schlüsseltechnologie zur Entwicklung biomagnetischer Schnittstellen, die zunächst in der medizinischen Diagnostik, z.B. MEG, MKG, und womöglich zukünftig auch in der Prothesensteuerung oder allgemein in der Mensch-Maschinen-Interaktion zur Anwendung kommen kann.

Das Funktionsprinzip heutiger ME-Sensoren liegt in der mechanischen Kraftkopplung von magnetostriktiven und piezoelektrischen Materialien in einem Materialverbund.

Magnetostriktive Materialien, z.B. ferromagnetische Übergangsmetalle Fe, Ni, Co und deren Legierungen, Verbindungen der Seltenen Erden Tb, Dy, Sm mit den ferromagnetischen Übergangsmetallen, z.B. TbFe2, SmFe2, oder auch ferromagnetische Gläser vorwiegend enthaltend die Elemente Eisen, Kobalt, Bor oder Silizium in variierenden Anteilen, erfahren eine reversible Längenänderung entlang der Richtung eines auf sie einwirkenden Magnetfeldes. Verbindet man ein magnetostriktives Material stoffschlüssig mit einem Piezoelektrikum, z.B. Bleizirkonattitanat PZT, Polyvinylidenfluorid PVDF, Aluminiumnitrid AIN, so bewirkt die magnetostriktive Längenänderung zugleich eine Kraft auf das Piezoelektrikum, was dort zu einer strukturellen Ladungsverschiebung führt und eine messbare Piezospannung nach sich zieht. Diese Spannung kann als Maß für die magnetische Feldstärke elektronisch erfasst und ausgewertet werden.

Zu den einfachsten Ausführungsformen eines ME-Sensors zählt ein sogenannter Biegebalkensensor. Dieser weist - oft auf einem Glasträger oder auf einem Halbleitersubstrat - eine Abfolge verschiedener Materialschichten auf, wobei wenigstens eine Schicht aus einem magnetostriktiven Material und wenigstens eine weitere Schicht aus einem Piezoelektrikum besteht. In der gängigen Bauweise sind zusätzlich Elektroden oberhalb und unterhalb der piezoelektrischen Schicht angeordnet, um die Piezospannung bei Deformation der üblich senkrecht zum Schichtverlauf gepolten Piezoschicht abzugreifen. Magnetostriktive Materialien sind gewöhnlich metallisch leitend und werden unmittelbar mit dem Piezoelektrikum kontaktiert, um direkt als eine der Elektroden zu dienen. Aber auch andere Aufbauvarianten für ME-Biegebalkensensoren sind bekannt.

Ein ME-Biegebalkensensor hat üblich die Form eines rechteckigen Streifens. Die Richtung, entlang der das magnetostriktive Material seine größte Längenänderung gegenüber kleinen Magnetfeldern zeigt, ist u. a. durch eine Temperaturbehandlung im vorbekannten Magnetfeld - "magnetic field annealing" - bei der Herstellung des Sensors einstellbar. In aller Regel wird diese Richtung mit der langen Achse der Streifen in Übereinstimmung gebracht. Unter der Einwirkung eines Magnetfeldes entlang der langen Achse verbiegt sich dann der Streifen infolge der unterschiedlichen Materialausdehnung schon bei kleinen Magnetfeldbeträgen und erzeugt so eine messbare Signalspannung.

Magnetostriktive und piezoelektrische Materialien können mit an sich bekannten Beschichtungstechniken aufeinander und/oder auf vorbestimmten Substraten abgeschieden werden. Die Herstellung von ME-Sensoren ist insoweit mit Prozessen der Silizium-Technologie kompatibel; insbesondere sind integrierte ME-Sensoren etwa in MEMS-Bauweise - Micro Electrical Mechanical Systems - herstellbar. Aber auch die getrennte Erzeugung von magnetostriktiven und piezoelektrischen Folien und das anschließende Verkleben beider zu einer ME-Folie sind geeignet, Magnetfeldsensoren nach dem beschriebenen Prinzip zu erzeugen.

ME-Sensoren sind mechanische Oszillatoren. Unter Einwirkung eines periodischen Magnetfeldes definierter Frequenz zeigen sie ein erzwungenes mechanisches Schwingungsverhalten. Erfolgt die Anregung dabei mit der mechanischen Resonanzfrequenz des ME-Sensors, dann rufen selbst sehr kleine Magnetfeldstärken sehr große Messspannungen hervor.

Biologisch erzeugte Magnetfelder weisen typisch nur Frequenzen der Größenordnungen 1 Hz bis ungefähr 100 Hz auf. Demgegenüber liegen die Resonanzfrequenzen gängiger ME-Sensoren gewöhnlich bei etlichen 100 Hz bis zu einigen 100 kHz. Das Verhältnis der im ME-Sensor hervorgerufenen elektrischen Feldstärkeamplitude zur anregenden magnetischen Feldstärkeamplitude wird als ME-Koeffizient, α_{ME}, bezeichnet. Zwischen Messungen von Magnetfeldern im Resonanzfall und weit außerhalb der Resonanz variiert der ME-Koeffizient typisch um zwei bis drei Größenordnungen.

Gewöhnlich werden ME-Sensoren auch außerhalb ihrer mechanischen Resonanz betrieben. Da man an einer möglichst großen Messdynamik, einem möglichst großen Signal-Rausch-Verhältnis und an der Linearität der Spannungsantwort auf das zu messende Magnetfeld interessiert ist, wählt man für den ME-Sensor üblich einen Arbeitspunkt im linearen Bereich der Magnetostriktionskennlinie.

Die Magnetostriktionskennlinie beschreibt die Längenausdehnung eines magnetostriktiven Materials entlang einer vorbestimmten Richtung, wenn es einer Magnetfeldstärke vom Betrag H ausgesetzt ist. Ein Vorzeichenwechsel von H entspricht dabei einer magnetischen Feldumkehr, und da beide Feldrichtungen denselben Effekt auf das Material haben, verläuft die Magnetostriktionskennlinie grundsätzlich symmetrisch zu H = 0. Die Magnetostriktionskennlinie zeigt um H = 0 einen parabolischen Verlauf, ist aber bei hohen Feldstärken dadurch beschränkt, dass alle magnetischen Domänen irgendwann gleich ausgerichtet sind. Sie besitzt folglich zwei Wendepunkte bei ± H_{B}, wo sie näherungsweise linear verläuft und die größten Steigungen aufweist.

Um den ME-Sensor in diesem vorteilhaften Arbeitspunkt zu betreiben, wird in vielen Fällen ein konstantes Bias-Magnetfeld der Feldstärke H_{B} durch das geeignete Anordnen von Stromleitern oder Permanentmagneten angelegt.

ME-Sensoren unterliegen internen und externen Störeinflüssen, u. a. thermischen Fluktuationen der elektronischen Materialeigenschaften und ungewollt übertragenen mechanischen Vibrationen durch Luft- oder Körperschall. Präzisionsmessungen erfordern daher häufig den Einbau des ME-Sensors in eine Messkammer, in der die Temperatur stabilisiert oder die sogar evakuiert werden kann. Gleichwohl können Vibrationen der Messkammer im Labor meist nicht ausgeschlossen werden, so dass auch über eine mechanisch gedämpfte Halterung des ME-Sensors immer noch Störungen in das Messsignal eingetragen werden können. Überhaupt ist die Verwendung einer solchen Messkammer für viele praktische Messaufgaben keine Option.

In der Arbeit von Xing et al., "Investigation of external noise and its rejection in magnetoelectric sensor design", J. Appl. Phys. 106, 024512 (2009) wird deshalb untersucht, wie man ME-Sensoren ausgestalten könnte, damit sie Störeinflüsse per Konstruktion unterdrücken bzw. vom Nutzsignal des Sensors separieren. Der Arbeit ist u. a. die leicht einzusehende Erkenntnis zu entnehmen, "that vibrational acoustic noise sources can be cancelled, if the structure of the sensor is designed to be mechanically symmetrical" (Abschnitt II A). Die Autoren kommen dann auch zu dem Schluss, dass ein Unimorph, der dem oben beschriebenen Biegebalkensensor entspricht, aufgrund seines asymmetrischen Aufbaus keine Fähigkeit zur Vibrationsunterdrückung oder -separierung besitzt (Abschnitt III A, s. auch Tabelle 1). Vielmehr werden im überwiegenden Teil der Arbeit symmetrische ME-Sensoren in Sandwichbauweise diskutiert, die sich zielgerecht ausgestalten lassen.

Neben den ME-Sensoren sind auch Stimmgabel-Sensoren zur Magnetfeldmessung bekannt. Das Funktionsprinzip besteht darin, einen mechanischen Oszillator - gewöhnlich in der Form einer Stimmgabel mit Zinken - zu Schwingungen in der Nähe seiner Resonanzfrequenz anzuregen, die Parameter der Oszillation - Frequenz, Phase, Amplitude - zu überwachen, und aus Änderungen dieser Parameter auf ein anwesendes Magnetfeld zu schließen. Etwa das Anordnen von Permanentmagneten an den Zinken der Stimmgabel, wie vorgeschlagen in der Druckschrift US 2007/0296410 A1, bewirkt, dass das Magnetfeld eine Kraft auf die schwingenden Zinken ausübt und die Parameter der Oszillation ändert. Sensoren nach demselben Prinzip sind auch in MEMS- Bauweise zu realisieren. Überdies wurde schon vorgeschlagen, die Zinken mit magnetostriktivem Material zu beschichten, um die Oszillation in Abhängigkeit von einem Magnetfeld zu beeinflussen. Ein anderer ME-Sensor wird von

### STEPHAN

MARAUSKA ET AL: im Paper "MEMS magnetic field sensor based on magnetoelectric
composites;MEMS magnetic field sensor based on magnetoelectric composites",JOURNAL
OF MICROMECHANICS & MICROENGINEERING, INSTITUTE OF PHYSICS PUBLISHING, BRISTOL,
GB, Bd. 22, Nr. 6, 22. Mai 2012 (2012-05-22), Seite 65024, XP020224204,ISSN: 0960-1317, DOI: 10.1088/0960-1317/22/6/065024, beschrieben.

Der eingangs beschriebene ME-Biegebalkensensor besticht durch seine einfache und kostengünstige Herstellbarkeit und erscheint gerade für biomagnetische Feldmessungen besonders geeignet.

Es ist daher die Aufgabe der Erfindung, eine Magnetfeldmessvorrichtung auf der Basis von ME-Biegebalkensensoren vorzuschlagen, die eine per Konstruktion bedingte Fähigkeit zur Vibrationskompensation aufweist und somit weitgehend unempfindlich gegenüber dem Eintrag mechanischer Schwingungen durch Luft- oder Körperschall ist. Die Aufgabe wird gelöst durch eine Magnetfeldmessvorrichtung umfassend einen Haltekörper und eine Mehrzahl magnetoelektrischer Biegebalkensensoren einzeln ausgebildet zur Ausgabe je eines elektrischen Spannungssignals unter Verbiegen bei Vorliegen eines Magnetfeldes, wobei die Biegebalkensensoren kraft- oder stoffschlüssig mit dem Haltekörper verbunden und sind, dadurch gekennzeichnet, dass
a. die Biegebalkensensoren mit parallel verlaufenden langen Achsen zur Detektion desselben Magnetfeldes angeordnet sind, so dass
b. die Magnetfeldmessvorrichtung durch ein zeitlich periodisches Magnetfeld zu einer mechanischen Schwingung erregbar ist, die
c. sich derart ausbildet, dass die Magnetfeldmessvorrichtung wenigstens einen Kraftknotenpunkt aufweist, an dem zu keiner Zeit eine durch die Schwingung bedingte resultierende Kraft angreift, und
d. die Magnetfeldmessvorrichtung eine Linearkombination der Spannungssignale der Biegebalkensensoren ausgibt.

Die in der Arbeit von Xing et al. (2009) geäußerte Feststellung, dass symmetrisch aufgebaute ME-Magnetfeldsensoren die Vibrationskompensation erlauben, wird von der Erfindung aufgegriffen und in eine neue Richtung fortgebildet.

Der Erfindungsansatz besteht darin, eine Mehrzahl von Biegebalkensensoren an einem gemeinsamen Haltekörper derart anzuordnen, dass alle Biegebalken zum einen dasselbe Magnetfeld messen und zum anderen Vibrationseinträge in die Gesamtanordnung in allen Biegebalken Störsignale erzeugen, die sich durch eine Linearkombination aller Ausgangsspannungen der Biegebalken auslöschen.

Der Haltekörper ist dabei ein starrer Körper, der eine mechanische Kopplung der Oszillationen aller Biegebalken ermöglicht. Der Haltekörper kann aus einem Halbleiter, einem Metall, einem Kunststoff, z.B. Polymethylmetacrylat PMMA, oder auch aus einem Glas bestehen. Er besitzt vorzugsweise eine N-zählige Symmetrieachse, wobei N eine natürliche Zahl größer als Eins ist. Der Haltekörper kann auch die Form eines Zylinders haben (N → ∞).

Die Biegebalken und der Haltekörper zusammen sollen unter Einwirkung eines zeitlich periodischen Magnetfeldes mechanisch schwingfähig sein. Zu diesem Zweck sind die Biegebalken stoff- oder kraftschlüssig mit dem Haltekörper verbunden, beispielsweise verklebt, verlötet, versintert oder mit Klemmen befestigt. Vorzugsweise sind die streifenförmigen Biegebalken jeweils an einem Streifenende mit dem Haltekörper verbunden.

Die Gesamtheit aus der Anordnung der Biegebalken, dem Haltekörper und der Verschaltung der Biegebalken-Spannungsausgänge zur Bildung der geeigneten Linearkombination der Spannungssignale stellt - ggf. in baulicher Einheit - die erfindungsgemäße Magnetfeldmessvorrichtung dar. Diese Vorrichtung kann allein durch ein zeitlich periodisches Magnetfeld in eine mechanische Schwingung versetzt werden. Erfindungsgemäß existiert während dieser Schwingung wenigstens ein Punkt der Vorrichtung, der zu keinem Zeitpunkt in Bewegung versetzt wird, weil zu keiner Zeit eine durch die Schwingung bedingte, resultierende Kraft auf ihn wirkt. Ein solcher Punkt wird hier als Kraftknotenpunkt bezeichnet.

Der Kraftknotenpunkt wird allerdings durch Vibrationen, die von außen durch Luft- oder Körperschall in die Magnetfeldmessvorrichtung eingetragen werden, in Bewegung versetzt. Die Anordnung der Biegebalkensensoren detektiert dann in jedem einzelnen Biegebalken eine vibrationsbedingte Störung neben dem zu messenden Magnetfeld. Die erzeugten Spannungssignale sind für die einzelnen Biegebalken nicht nach Ursachen separierbar. Die Erfindung lehrt nun, dass eine Linearkombination der Spannungssignale gebildet werden kann, in der sich die Anteile der Vibrationsstörung kompensieren, wenn die Biegebalken so angeordnet sind, dass die Vorrichtung wenigstens einen Punkt aufweist, der bei Vorliegen eines zeitlich periodischen Magnetfeldes und in Abwesenheit einer Vibration während der durch das Magnetfeld hervorgerufenen Schwingung zu jeder Zeit in Ruhe verbleibt.

Die Erfindung wird nachfolgend näher erläutert auch anhand von Beispielen und Zeichnungen. Dabei zeigt:
- Fig. 1: eine Skizze eines Querschnitts durch eine Anordnung von drei gleichartigen ME-Biegebalkensensoren (Rechtecke) mit Kräften, die infolge einer Vibrationsstörung auf die Anordnung einwirken;
- Fig. 2: eine Skizze eines Querschnitts durch eine Anordnung von vier ME-Biegebalkensensoren (Rechtecke) umfassend zwei Paare paarweise gleichartiger Sensoren, befestigt an einem würfel- oder quaderförmigen Haltekörper und
- Fig. 3: eine Skizze eines Querschnitts durch eine Anordnung von vier ME-Biegebalkensensoren (Rechtecke) umfassend zwei Paare paarweise gleichartiger Sensoren, befestigt an einem Sechskant-Haltekörper.

Für die weitere Beschreibung sind zunächst einige Begriffsklärungen zweckmäßig:
Ein ME-Biegebalkensensor in Streifenform weist eine erste und eine zweite Flachseite auf. Gewöhnlich werden die Sensoren so hergestellt, dass beide Flachseiten in Abwesenheit eines zu messenden Magnetfeldes gleich lang sind, der Streifen also gerade ist.

Dabei wird in dieser Beschreibung stets angenommen, dass sich der ME-Biegebalkensensor von Vornherein in einem vorteilhaften Arbeitspunkt zur Magnetfeldmessung befindet. Dies kann, wie weiter oben erläutert, durch das Anordnen von Permanentmagneten erfolgen, welche ein konstantes Bias-Feld entlang der langen Achse des Biegebalkens erzeugen. Es ist aber auch bekannt, Biegebalken als Schichtsysteme mit wenigstens einer antiferromagnetischen Schicht auszugestalten, die einen solchen Arbeitspunkt mittels Pinning der Elementardipole durch Exchange Bias erzielen. Ein solcher Aufbau weist nur ein sehr schwaches, konstruktionsbedingtes, zeitlich konstantes Magnetfeld auf im Vergleich zu dem herkömmlichen Bias-Magnetfeld. Unabhängig davon, auf welche Weise der Arbeitspunkt genau eingestellt wird, wird von nun an vorausgesetzt, dass er im linearen Bereich der Magnetostriktionskennlinie der magnetostriktiven Schicht des Biegebalkens liegt. In der weiteren Beschreibung werden konstruktionsbedingte, zeitlich konstante Magnetfelder, insbesondere Bias-Magnetfelder, die den Arbeitspunkt des ME-Biegebalkens festlegen, nicht mehr explizit angesprochen.

Liegt ein zu messendes Magnetfeld mit vorbestimmter Richtung entlang der langen Achse des Biegebalkens vor, ändert sich die Länge wenigstens einer der beiden Flachseiten, und der Biegebalken verbiegt sich. Es soll im Folgenden als Oberseite des Streifens diejenige Flachseite bezeichnet werden, die in dem durch ein Magnetfeld mit vorbestimmter Richtung verbogenen Zustand die längere ist. Entsprechend wird die gegenüberliegende kürzere Flachseite von nun an die Unterseite genannt. Im Folgenden beziehen sich die Bezeichnungen Ober- und Unterseite aller ME-Biegebalken einer Anordnung immer auf dieselbe vorbestimmte Magnetfeldrichtung. Dies ist hier unproblematisch, da in der erfindungsgemäßen Magnetfeldmessvorrichtung alle Biegebalken stets so angeordnet sind, dass ihre langen Achsen parallel verlaufen.

Es ist für den Zweck der Erfindung vorteilhaft, im Idealfall baugleiche ME-Biegebalkensensoren in die erfindungsgemäße Anordnung zu bringen. Doch ist Baugleichheit eine starke Anforderung, die aus praktischen Gründen nicht immer erfüllt werden kann. Für die Erfindung reicht es aus, wenn Biegebalkensensoren verwendet werden, die etwa die gleiche Masse und Länge besitzen und unter Einwirkung eines Magnetfeldes die gleiche Verbiegung zeigen und das gleiche Spannungssignal ausgeben.

Beispielsweise können Biegebalkensensoren erzeugt werden, die sich hinsichtlich der Substrate, z.B. Siliziumstreifen, der Funktionsmaterialien, z.B. Metglas und PZT, und aller Dimensionierungen - Längen, Schichtdicken, Schichtanordnung - nicht unterscheiden, aber verschiedene Elektrodenmaterialien, z.B. Gold oder Platin, für den Spannungsabgriff aufweisen. Die Elektrodenschichten von einigen Nanometern Dicke spielen für das mechanische Verhalten des Biegebalkens und das Spannungssignal des ME-Sensors keine Rolle. Diese Sensoren sind nicht baugleich, aber jedenfalls allein durch ihre mechanische oder elektrische Antwort auf ein Magnetfeld nicht voneinander zu unterscheiden. Sensoren mit dieser Eigenschaft werden im Kontext der weiteren Beschreibung als gleichartig bezeichnet.

Zum besseren Verständnis der Erfindung wird zunächst ein sehr einfaches Ausführungsbeispiel beschrieben.

An zwei gegenüberliegenden Flachseiten eines quaderförmigen Haltekörpers sind zwei gleichartige Biegebalkensensoren angeordnet. Beide Biegebalkensensoren sind mit je einem ihrer Balkenenden mit einer Klemme durch Andruck ihrer Unterseiten am Haltekörper befestigt und weisen mit ihren langen Achsen in dieselbe Richtung. Die Biegebalken stehen sich mit zueinander weisenden Unterseiten genau gegenüber in einem Abstand, der durch die Dimensionen des Haltekörpers bestimmt ist. Dieser Abstand soll klein sein, aber nicht so klein, dass sich die Biegebalken bei der Verbiegung berühren könnten. Rein optisch sieht diese Ausführungsform einer Stimmgabel ähnlich, deren Zinken durch die Biegebalken gebildet werden. Der Aufbau ist mechanisch schwingfähig. Er besitzt eine 2-zählige Rotationssymmetrieachse, nämlich durch den Mittelpunkt des Haltekörpers parallel zu den langen Achsen der Biegebalken verlaufend.

Ein zeitlich periodisches Magnetfeld, das von beiden Biegebalken gleichzeitig detektiert wird, bewirkt nun die Verbiegung der Biegebalken aufeinander zu und - bei Feldrichtungsumkehr - voneinander weg. Der Aufbau vollführt eine erzwungene mechanische Schwingung mit der Periode des Magnetfeldes, also nicht unbedingt mit der Resonanzfrequenz des Aufbaus, die deutlich höher liegen kann. Es liegt hier keine Variante eines an sich bekannten Stimmgabel-Sensors vor.

Gleichwohl wird eine Schwingungsbewegung vollführt, die mit der bekannten Stimmgabel-Oszillation vergleichbar ist. Insbesondere existiert wenigstens ein Punkt der Vorrichtung, der sich zu jedem Zeitpunkt im Kräftegleichgewicht befindet, also keine resultierende Kraft aus der Schwingung erfährt und in Ruhe bleibt: ein Kraftknotenpunkt, der hier auf der Rotationssymmetrieachse im Haltekörper liegt.

Beide Biegebalken erzeugen während der Schwingung ein Spannungssignal, das bei gleichartigen Sensoren - innerhalb der durch Messungenauigkeiten begründeten Fehlergrenzen - zu jeder Zeit hinsichtlich Betrag und Vorzeichen gleich groß ist. Addiert man beide Signale, erhält man die doppelte ME-Sensorspannung für ein vorliegendes Magnetfeld in Abwesenheit einer störenden Vibration.

Tritt nun eine Vibration durch Luft- oder Körperschalleintrag während der Magnetfeldmessung zusätzlich auf, so verursacht diese Störung in jedem Punkt der Vorrichtung eine weitere - in der Regel selbst zeitabhängige - Krafteinwirkung. Die relativ beweglichen Biegebalken erfahren hierdurch zusätzliche Verbiegungen, wenn eine Kraftkomponente senkrecht zu den Flachseiten der Biegebalken angreift. Allerdings weist diese Kraftkomponente an beiden Biegebalken zu jeder Zeit in die gleiche Richtung, d. h. bei dem einen Biegebalken wird die Verbiegung verstärkt und bei dem anderen gleichzeitig abgeschwächt. Der Einfluss der Vibration auf die Spannungssignale der Biegebalken ist insofern jederzeit gegenphasig, und in der Tat zeigt sich bei der Addition der beiden Signale, dass die Vibration im Summensignal kompensiert ist.

Die eingangs genannte Linearkombination der Spannungssignale der Biegebalken ist somit beispielsweise und bevorzugt die Addition.

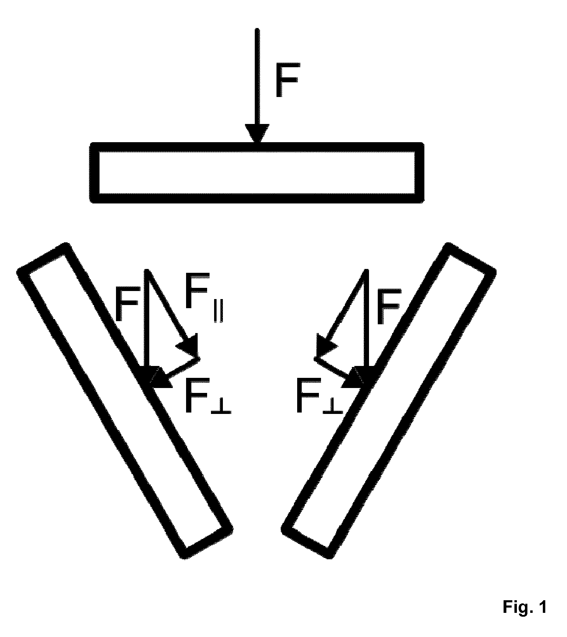

Dasselbe gilt für das zweite Ausführungsbeispiel, das auch in Fig. 1 skizziert ist. Der nicht dargestellte Haltekörper kann hier beispielsweise ein Block aus PMMA mit ebenen Seitenwänden und einer 3N-zähligen Rotationssymmetrieachse sein, wobei N eine natürliche Zahl ist. An drei durch Rotation ineinander überführbaren Seitenwänden des Haltekörpers werden drei gleichartige ME-Biegebalken angeordnet und z.B. mit einem Epoxidharz angeklebt. Die langen Achsen der Biegebalken weisen wie zuvor parallel in dieselbe Richtung, die zugleich die Messrichtung für das Magnetfeld und die Richtung der Rotationssymmetrieachse ist. In Fig. 1 ist die Anordnung der Biegebalken durch einen Querschnitt senkrecht zu den langen Achsen skizziert, wobei jedes Rechteck einen Querschnitt durch einen Biegebalken darstellen soll. Auch hier sind exemplarisch die Unterseiten aller Biegebalken der Rotationsymmetrieachse, also dem Innern der Anordnung, zugewandt. Folglich biegen sich alle Biegebalken unter Einwirkung eines Magnetfeldes in gleicher Weise nach innen, also auf die Rotationssymmetrieachse zu, oder nach außen bei Feldumkehr. Alle Biegebalken sollen dasselbe Feld detektieren und somit die gleichen Spannungssignale ausgeben, deren Summe dann die dreifache ME-Sensorspannung eines einzelnen Biegebalkens ist.

Weiterhin ist in Fig. 1 eine von außen angreifende Kraft F als Vektorpfeil eingetragen. Sie ist in der Skizze lediglich zur Verdeutlichung senkrecht zur Flachseite eines der Biegebalken gerichtet und biegt diesen auf die Rotationssymmetrieachse der Vorrichtung zu. Jeder der beiden anderen Biegebalken erfährt hingegen eine Verbiegung von der Rotationssymmetrieachse weg, und zwar nur durch die senkrecht am jeweiligen Biegebalken angreifende Komponente von F, die jeweils gerade den halben Betrag von F besitzt. Die Kraft F bewirkt auch hier Störanteile in den Spannungssignalen aller drei Biegebalkensensoren, und wie zuvor löschen sich gerade diese Störanteile bei der Addition der drei Spannungen gegenseitig aus. Greift die Kraft aus einer anderen Richtung als in Fig. 1 gezeigt an, dann kann man sie in ihre Komponenten parallel und senkrecht zu einem der Biegebalken zerlegen, und die vorstehende Argumentation gilt für die Komponenten genauso. Der Einfluss einer Vibration wird durch die Anordnung der gleichartigen Biegebalken und die Tatsache, dass der Haltekörper überall für rotationssymmetrisch gleiche mechanische Verhältnisse sorgt, kompensiert.

Der Fachmann sieht nach dem Gesagten ohne Weiteres ein, dass sich weitere Ausgestaltungen einer erfindungsgemäßen Magnetfeldmessvorrichtung sehr leicht entwerfen lassen, wobei der Haltekörper eine N-zählige Rotationssymmetrie bezüglich einer Symmetrieachse aufweist, und M gleichartige Biegebalkensensoren derart mit ihren langen Achsen parallel zur Symmetrieachse angeordnet und mit dem Haltekörper verbunden sind, dass die Magnetfeldmessvorrichtung bezüglich der Symmetrieachse eine M-zählige Rotationssymmetrie aufweist, wobei N eine natürliche Zahl größer als Eins und M ein Teiler von N und größer als Eins ist.

Im ersten Ausführungsbeispiel gilt N = M = 2. Für das zweite Ausführungsbeispiel kann man N = M = 3 verwenden, aber ebenso auch N = 6 und M = 3.

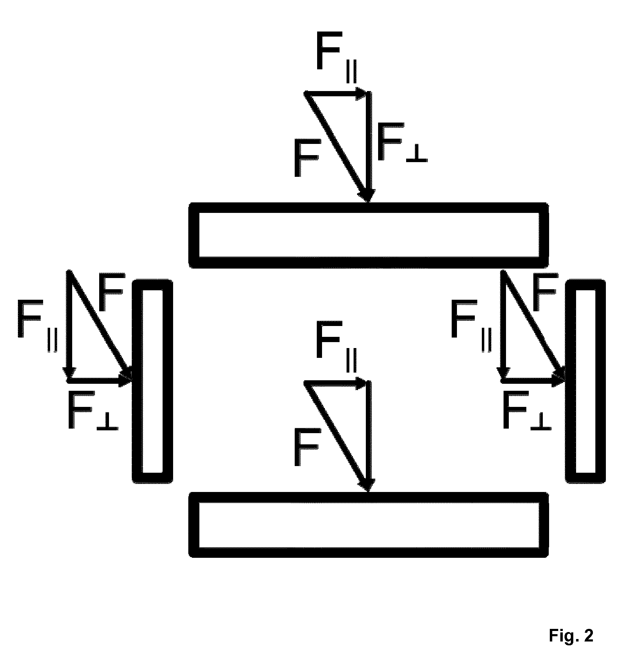

Als drittes Ausführungsbeispiel soll erneut ein Quader als Haltekörper vorgestellt werden, der eine zweizählige Rotationssymmetrieachse und zwei Paare gleicher ebener, durch Rotation ineinander überführbarer Seitenwände aufweist. Es reicht nun aus, an einem Paar gleicher Seitenwände ein Paar gleichartiger ME-Biegebalkensensoren - wie zuvor mit ihrer Unterseite zur Rotationssymmetrieachse weisend - anzuordnen, womit man beim ersten Ausführungsbeispiel angelangt. Das zweite Paar gleicher Seitenwände kann zusätzlich genauso mit einem zweiten Paar gleichartiger Biegebalken versehen werden, wobei es aber keineswegs erforderlich ist, dass auch die Sensoren des ersten und des zweiten Paares gleichartig sind. Beispielsweise kann man ein Paar langer und ein Paar kurzer Biegebalken verwenden. Die Vibrationskompensation ergibt sich wie zuvor aus der Symmetrie des Aufbaus, und auch hier ist wieder die Summe aller Spannungssignale der Biegebalkensensoren vibrationskompensiert. Eine Querschnittsskizze der Anordnung ist in Fig. 2 zu sehen, wobei auch eine von außen angreifende Kraft F und an jedem Biegebalken eine Kraftzerlegung nach senkrecht und parallel angreifenden Komponenten dargestellt sind.

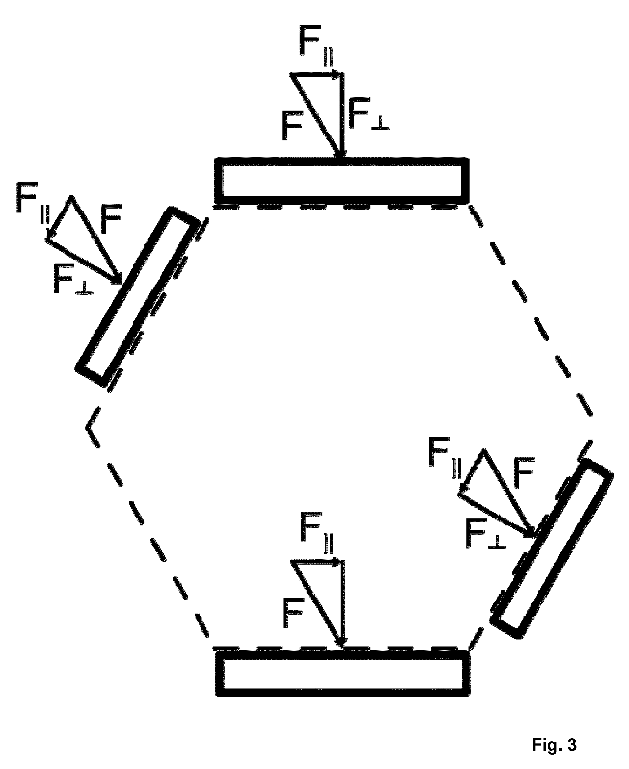

Das vierte und letzte Ausführungsbeispiel betrifft einen Sechskant-Haltekörper, also mit sechszähliger Rotationssymmetrie und sechs gleichen Seitenwänden. An diesen können nach Wahl des Anwenders ein, zwei oder drei Paare von Biegebalken angeordnet werden. Auch hier sind die Biegebalkensensoren paarweise gleichartig, wobei jedes Paar zwei gegenüberliegende Seitenwände des Haltekörpers belegt. Beispielsweise zeigt Fig. 3 gestrichelt den Querschnitt des Haltekörpers, ein erstes Paar gleichartiger Biegebalken (Rechtecke) in der 6 Uhr und 12 Uhr Position, ein zweites Paar gleichartiger Biegebalken in der 4 Uhr und 10 Uhr Position und die von außen angreifenden Störkräfte analog zu Fig. 2. Im Übrigen können sich die Sensor-Paare untereinander unterscheiden, und insbesondere verschiedene Materialien, Abmessungen und insbesondere auch Resonanzfrequenzen aufweisen. Magnetfeldmessvorrichtungen in dieser Bauweise ähneln den an sich bekannten ME-Sensorarrays, die u. a. dazu verwendet werden können, zeitlich periodische Magnetfelder mit komplexem oder veränderlichem Frequenzspektrum empfindlich zu detektieren. Dass erfindungsgemäße Kennzeichen ist hier, dass der Haltekörper eine 2N-zählige Rotationssymmetrie bezüglich einer Symmetrieachse aufweist, und M Paare paarweise gleichartiger Biegebalkensensoren derart mit ihren langen Achsen parallel zur Symmetrieachse angeordnet und mit dem Haltekörper verbunden sind, dass die Magnetfeldmessvorrichtung bezüglich der Symmetrieachse eine zweizählige Rotationssymmetrie aufweist, wobei N und M natürliche Zahlen sind.

Zur Verdeutlichung sei noch einmal ausdrücklich gesagt, dass für die vorgenannten Ausführungsbeispiele von einer Rotationssymmetrie der Magnetfeldmessvorrichtung die Rede ist, die nicht nur den Haltekörper und die geometrische Anordnung der Biegebalken am Haltekörper beschreibt, sondern die auch die Orientierung dieser Biegebalken bezüglich der Rotationsachse umfasst. Die Unterseiten der Biegebalken in der Anordnung können wahlweise der Rotationsachse zu- oder abgewandt sein, jedoch stets so, dass gleichartige Biegebalken symmetrisch orientiert sind und sich - ggf. wenigstens paarweise - bei Vorliegen eines detektierbaren Magnetfeldes synchron auf die Rotationsachse zu oder von ihr weg verbiegen. Dann ermöglicht die über den Haltekörper eingeführte mechanische Kopplung der Biegebalken die Erhaltung der symmetrischen mechanischen Verhältnisse, solange die Magnetfeldmessvorrichtung eine Schwingung nur aufgrund eines zeitlich periodischen Magnetfeldes vollführt.

Tritt zusätzlich eine Störung der Magnetfeldmessvorrichtung durch den Eintrag einer Vibration via Luft- oder Körperschall auf, wird die per Konstruktion erzeugte Symmetrie der Bewegung gestört, und jeder Biegebalken erfasst einen Anteil der Störung und gibt eine gestörtes Spannungssignal aus. Wie zuvor erläutert, löschen sich die Störanteile jedoch in der Summe der Signale bei gleichartigen Biegebalken gegenseitig aus. Falls nicht alle verwendeten Biegebalken gleichartig sind, wie in den beiden letzten Ausführungsbeispielen, dann kann es zweckmäßig sein, die Spannungssignale verschiedener Biegebalkenpaare auch verschieden in der Summenbildung zu gewichten. Deshalb wird hier verallgemeinert von der Bildung einer Linearkombination aller Spannungssignale der Biegebalken als Ausgabe der erfindungsgemäßen Magnetfeldmessvorrichtung gesprochen.

Das der Erfindung zugrundeliegende Konzept kann, wie die Ausführungsbeispiele zeigen, nicht vollständig und umfassend allein mit dem Vorsehen einer N-zähligen Rotationssymmetrieachse für die vibrationskompensierte Magnetfeldmessvorrichtung beschrieben werden, denn dies ist ein hinreichendes, aber kein notwendiges Kriterium. Wesentlich ist vielmehr das Vorliegen einer mechanischen Symmetrie, die durchgehend auch während der Schwingung der Magnetfeldmessvorrichtung gewahrt wird, wenn diese Schwingung nur vom detektierten Magnetfeld herrührt. Die Existenz wenigstens eines Punktes in der Vorrichtung, der sich auch während einer solchen Schwingung zu keiner Zeit bewegt, wird deshalb als erkennbarer Indikator einer erfindungsgemäßen Magnetfeldmessvorrichtung betrachtet. Ein solcher Punkt muss durchgehend kräftefrei sein und wird daher hier als Kraftknotenpunkt bezeichnet.

Selbstverständlich wirkt auf jeden Punkt der Vorrichtung stets die Schwerkraft. Die Vorrichtung ist zur Lagefixierung an wenigstens einem Befestigungspunkt mit einem geeigneten Stativ zu verbinden. Das Stativ kann ein Gestänge oder auch das Gehäuse einer Messkammer sein, in jedem Fall ist das Stativ ein Leiter für Körperschall. Der Befestigungspunkt der Magnetfeldmessvorrichtung wird durch die Verbindung mit dem Stativ selbst zum Eintragspunkt für Körperschall in den Sensor. Es ist besonders vorteilhaft, diesen Befestigungspunkt möglichst in der Nähe eines Kraftknotenpunktes zu wählen und überdies die Körperschallübertragung vom Stativ durch Vorsehen einer schalldämpfenden Verbindung, z.B. durch elastische Greiferkissen in einer Klemmverbindung, zu unterdrücken.

## Patentansprüche

1. Magnetfeldmessvorrichtung umfassend einen Haltekörper und eine Mehrzahl magnetoelektrischer Biegebalkensensoren einzeln ausgebildet zur Ausgabe je eines elektrischen Spannungssignals unter Verbiegen bei Vorliegen eines Magnetfeldes, wobei die Biegebalkensensoren kraft- oder stoffschlüssig mit dem Haltekörper verbunden sind,
**dadurch gekennzeichnet, dass**
a. die Biegebalkensensoren mit parallel verlaufenden langen Achsen zur Detektion desselben Magnetfeldes angeordnet sind, so dass
b. die Magnetfeldmessvorrichtung durch ein zeitlich periodisches Magnetfeld zu einer mechanischen Schwingung erregbar ist, die
c. sich derart ausbildet, dass die Magnetfeldmessvorrichtung wenigstens einen Kraftknotenpunkt aufweist, an dem zu keiner Zeit eine durch die Schwingung bedingte resultierende Kraft angreift, und
d. die Magnetfeldmessvorrichtung eine Linearkombination der Spannungssignale der Biegebalkensensoren ausgibt,
und **gekennzeichnet dadurch dass** durch die Anordnung der Biegebalksensoren eine mechanische Symmetrie vorliegt, die durchgehend auch während der Schwingung der Magnetfeldmessvorrichtung gewahrt wird, so dass Vibrationseinträge in die Gesamtanordnung in allen Biegebalken Störsignale erzeugen, die sich durch eine Linearkombination aller Ausgangsspannungen der Biegebalken auslöschen.

2. Magnetfeldmessvorrichtung nach Anspruch 1,
**dadurch gekennzeichnet, dass**
der Haltekörper eine N-zählige Rotationssymmetrie bezüglich einer Symmetrieachse aufweist, und M gleichartige Biegebalkensensoren derart mit ihren langen Achsen parallel zur Symmetrieachse angeordnet und mit dem Haltekörper verbunden sind, dass die Magnetfeldmessvorrichtung bezüglich der Symmetrieachse eine M-zählige Rotationssymmetrie aufweist, wobei N eine natürliche Zahl größer als Eins und M ein Teiler von N und größer als Eins ist.

3. Magnetfeldmessvorrichtung nach Anspruch 1,
**dadurch gekennzeichnet, dass**
der Haltekörper eine 2N-zählige Rotationssymmetrie bezüglich einer Symmetrieachse aufweist, und M Paare paarweise gleichartiger Biegebalkensensoren derart mit ihren langen Achsen parallel zur Symmetrieachse angeordnet und mit dem Haltekörper verbunden sind, dass die Magnetfeldmessvorrichtung bezüglich der Symmetrieachse eine zweizählige Rotationssymmetrie aufweist, wobei N und M natürliche Zahlen sind.

4. Magnetfeldmessvorrichtung nach einem der vorangehenden Ansprüche,
**dadurch gekennzeichnet, dass**
die Magnetfeldmessvorrichtung die Summe aller Spannungssignale der Biegebalkensensoren ausgibt.

## Claims

1. A magnetic-field measurement device comprising a holding body and a plurality of magnetoelectric bending beam sensors individually configured to output one electrical voltage signal in each case upon deflection in the presence of a magnetic field, wherein the bending beam sensors are connected in non-positive manner or by a material bond to the holding body,
**characterised in that**
a. the bending beam sensors are arranged with long axes extending parallel for the detection of the same magnetic field, so that
b. the magnetic-field measurement device can be excited by a temporally periodic magnetic field into mechanical oscillation which
c. develops such that the magnetic-field measurement device has at least one force node, on which a resultant force which is due to the oscillation at no time acts, and
d. the magnetic-field measurement device outputs a linear combination of the voltage signals of the bending beam sensors, and **characterised in that** owing to the arrangement of the bending beam sensors mechanical symmetry is present, which is maintained continuously also during the oscillation of the magnetic-field measurement device, so that vibration inputs into the entire arrangement generate spurious signals in all the bending beams, which signals are extinguished by a linear combination of all the output voltages of the bending beams.

2. A magnetic-field measurement device according to Claim 1,
**characterised in that**
the holding body exhibits an N-fold rotational symmetry with respect to an axis of symmetry, and M similar bending beam sensors are arranged with their long axes parallel to the axis of symmetry and are connected to the holding body such that the magnetic-field measurement device exhibits an M-fold rotational symmetry with respect to the axis of symmetry, wherein N is a natural number greater than one and M is a divisor of N and greater than one.

3. A magnetic-field measurement device according to Claim 1,
**characterised in that**
the holding body exhibits an 2N-fold rotational symmetry with respect to an axis of symmetry, and M pairs of similar bending beam sensors in pairs are arranged with their long axes parallel to the axis of symmetry and are connected to the holding body, such that the magnetic-field measurement device exhibits a two-fold rotational symmetry with respect to the axis of symmetry, wherein N and M are natural numbers.

4. A magnetic-field measurement device according to one of the preceding claims,
**characterised in that**
the magnetic-field measurement device outputs the sum of all the voltage signals of the bending beam sensors.

## Revendications

1. Dispositif de mesure de champ magnétique comprenant un élément support et une pluralité de capteurs à barre flexible magnétoélectriques, chacun étant conçu pour émettre un signal de tension électrique en cas de flexion en présence d'un champ magnétique, les capteurs à barre flexible étant reliés à l'élément support par force ou par liaison de matière,
**caractérisé en ce que**
a) les capteurs à barre flexible sont disposés avec leurs axes longitudinaux s'étendant parallèlement pour la détection du même champ magnétique, de telle sorte que
b) le dispositif de mesure de champ magnétique peut être excité par un champ magnétique périodique dans le temps en conduisant à une oscillation mécanique,
c) qui se développe de telle sorte que le dispositif de mesure de champ magnétique présente au moins un noeud de force sur lequel ne s'exerce à aucun moment une force résultante causée par l'oscillation, et
d) le dispositif de mesure de champ magnétique délivre une combinaison linéaire des signaux de tension des capteurs à barre flexible,
et **caractérisé en ce qu'**il résulte de la disposition des capteurs à barre flexible une symétrie mécanique qui est maintenue sans interruption, y compris durant l'oscillation du dispositif de mesure de champ magnétique, de sorte que les introductions de vibrations dans l'ensemble du dispositif génèrent des signaux de perturbation dans toutes les barres flexibles, lesquels signaux disparaissent par une combinaison linéaire de toutes les tensions de sortie des barres flexibles.

2. Dispositif de mesure de champ magnétique selon la revendication 1,
**caractérisé en ce que**
l'élément support présente une symétrie de rotation d'ordre N par rapport à un axe de symétrie, et M capteurs à barre flexible similaires sont disposés avec leurs axes longitudinaux parallèles à l'axe de symétrie et sont reliés à l'élément support, de telle sorte qu'un dispositif de mesure de champ magnétique présente une symétrie de rotation d'ordre M par rapport à l'axe de symétrie, N étant un nombre entier supérieur à un et M étant un diviseur de N et supérieur à un.

3. Dispositif de mesure de champ magnétique selon la revendication 1,
**caractérisé en ce que**
l'élément support présente une symétrie de rotation d'ordre 2N par rapport à un axe de symétrie, et M paires de capteurs à barre flexible semblables par paires sont disposées avec leurs axes longitudinaux parallèles à l'axe de symétrie et sont reliées à l'élément support, de telle sorte que le dispositif de mesure de champ magnétique présente une symétrie de rotation d'ordre 2 par rapport à l'axe de symétrie, N et M étant des nombres entiers.

4. Dispositif de mesure de champ magnétique selon l'une des revendications précédentes,
**caractérisé en ce que**
le dispositif de mesure de champ magnétique délivre la somme de tous les signaux de tension des capteurs à barre flexible.
